# EUROPÄISCHE PATENTANMELDUNG

(11) **EP 0 805 387 A1**
(43) Veröffentlichungstag der Anmeldung: **05.11.1997**
(21) Anmeldenummer: 97106403.5
(22) Anmeldetag: 17.04.1997
(51) Int. Cl.: G06F 1/32, H03K 19/00

(54) **Integrierte Schaltungsanordnung zur Reduzierung der Stromaufnahme**

(30) Priorität: 29.04.1996 DE 19617172
(71) Anmelder: SIEMENS AKTIENGESELLSCHAFT, 80333 München (DE)
(72) Erfinder: Wagner, Wolfgang, 81539 München (DE)

(57) **Zusammenfassung**

Die erfindungsgemäße integrierte Schaltungsanordnung weist eine Vielzahl von Funktionseinheiten auf, welche über einen Bus miteinander verbunden sind. Erfindungsgemäß wird zwischen den Busleitungen und der jeweiligen Funktionseinheit eine Zwischenspeichereinheit geschaltet, die durch ein Steuersignal aktiviert wird. Die Funktionseinheit wird dann nur wenn diese angesteuert wird, mit den jeweiligen Busleitungen verbunden.

## Beschreibung

Die Erfindung betrifft eine integrierte Schaltungsanordnung zur Reduzierung der Stromaufnahme gemäß dem Oberbegriff des Anspruchs 1.

Bei integrierten Schaltungen, insbesondere hochintegrierten Mikroprozessoren und Mikrocontrollern werden zunehmend Stromsparmodi gefordert. Aus dem Siemens Datenbuch 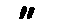 Microcontrollers Data Catalog 1990" ist auf Seite 465ff der Siemens 16-Bit Mikrocontroller SAB 80C166 beschrieben. Dieser weist einen Stromsparmodus auf, welcher softwaremäßig aktiviert wird und währenddem nur noch eine Versorgungsspannung größer 2,5 V benötigt wird. In Figur 3 auf Seite 471 ist das Blockschaltbild dieses Mikrocontrollers dargestellt. Wie zu sehen ist, sind eine Vielzahl von internen Funktionseinheiten mit der zentralen Recheneinheit über jeweilige Busleitungen verbunden.

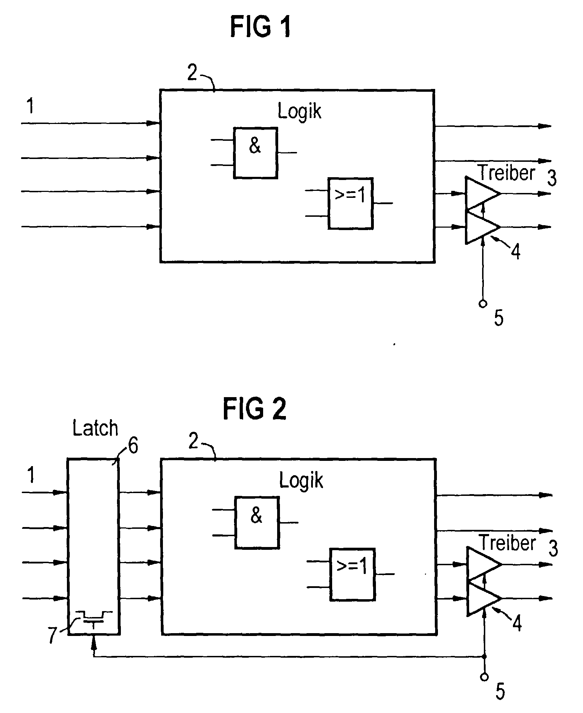

Figur 2 der vorliegenden Erfindung zeigt im prinzipiellen Verschaltung derartiger interner Funktionseinheiten. Mit 1 sind die Busleitungen bezeichnet, die von und/oder zu der zentralen Recheneinheit führen. Mit 2 ist eine Funktionseinheit dargestellt, welche Logik, Treiber usw. enthält. Der Ausgang der Funktionseinheit 2 wird über Treiber 4, von denen lediglich zwei beispielhaft dargestellt sind, an externe Ausgangsleitungen 3 verbunden. Die Treiber 4 werden von einem Steuersignal über die Leitung 5 aktiviert.

Nachteil einer derartigen Anordnung ist, daß diese Funktionseinheiten permanent mit dem Bus 1 der zentralen Recheneinheit verbunden sind und somit die an diesen Leitungen 1 anliegenden Signale verarbeiten. Bei CMOS-Schaltungen wird genau durch dieses Schalten der Signale Strom verbraucht. Dies ist teils durch den Querstrom aber hauptsächlich durch das Umladen der Lastkapazitäten bedingt.

Aufgabe der vorliegenden Erfindung ist es, eine integrierte Schaltungsanordnung anzugeben, die die Stromaufnahme von hochintegrierten CMOS-Schaltungen reduziert.

Diese Aufgabe wird durch den kennzeichnenden Teil des Anspruchs 1 gelöst. Weiterbildungen sind Kennzeichen der Unteransprüche.

Vorteil der vorliegenden Erfindung ist es, daß nur diejenigen Funktionseinheiten in einem hochintegrierten Baustein, wie z.B. einem Mikroprozessor oder einem Mikrocontroller, aktiviert werden, deren Ergebnisse auf den jeweiligen Ausgangsleitungen benötigt werden. Alle anderen Funktionseinheiten werden zu diesem Zeitpunkt von dem zentralen Bus abgekoppelt.

In einer vorteilhaften Ausgestaltung kann zur Abkoppelung der Funktionseinheiten das Freigabesignal der jeweiligen Ausgangstreiber der Funktionseinheiten verwendet werden. Hierzu kann vorteilhafterweise ein einfaches Latch verwendet werden, welches zwischen zentralem Bus und jeweiliger Funktionseinheit geschaltet wird.

Der Latch kann vorteilhafterweise aus einem einfachen Transfergate bestehen.

Die Erfindung wird nachfolgend anhand von zwei Figuren näher erläutert. Es zeigen
Figur 1 eine erfindungsgemäße Schaltungsanordnung zur Ansteuerung einer Funktionseinheit und
Figur 2 eine Schaltungsanordnung gemäß dem Stand der Technik.

Da in einem komplexen Baustein, wie einem Mikrocontroller die Ergebnisse auf den Ausgangsleitungen von Schaltungsteilen nicht zu jedem Zeitabschnitt von Bedeutung sind, wird erfindunsgemäß nur diejenige Funktionseinheit aktiviert, die zum jeweiligen Zeitabschnitt mit der zentralen Recheneinheit in Verbindung steht. Ein Mikroprozessor weist z.B. mehrere Verarbeitungseinheiten wie z.B. Addierwerke, Schiebeeinheiten usw. auf, wobei abhängig vom Befehl jeweils nur das Ergebnis einer Einheit wichtig ist und weiterverarbeitet wird. Da jedoch die Operanden an den Eingängen aller Einheiten parallel anliegen und diese Operanden sich von Befehl zu Befehl ständig ändern, wird auf die jeweilig angeschlossene Logikschaltung in den einzelnen Einheiten hin- und hergeschaltet, obwohl das Ergebnis dieser Einheit nicht benötigt wird. Bei CMOS-Schaltungen wird nur das Schalten der Signale Strom verbraucht. Dies ist durch den Querstrom und hauptsächlich durch das Umladen der Lastkapazitäten bedingt.

In Figur 1 wird dem dadurch abgeholfen, daß vor jede Funktionseinheit ein Latch 6 geschaltet wird. In Figur 1 ist lediglich eine Funktionseinheit 2 dargestellt und der interne zentrale Bus ist durch vier Leitungen 1 angedeutet. Zwischen diesem internen Bus 1 und der Logikeinheit 2 ist ein Latch 6 geschaltet, welches von dem Ansteuersignal 5 angesteuert wird, welches üblicherweise zur Ansteuerung der Ausgangstreiber 4 verwendet wird. Es könnte aber auch ein eigenes Ansteuersignal zensiert werden.

Durch dieses Latch 6, an den Eingängen einer Funktionseinheit 2 kann über den Steuereingang 5 des Latches 6 bei nicht benötigtem Ergebnis das Latch 6 auf Speichern geschaltet werden, womit kein Schalten innerhalb der Einheit 2 stattfindet und somit auch kein Strom mit Ausnahme von Leckströmen, die aber sehr viel kleiner sind.

Da in den meisten Fällen die Funktionseinheiten 2 externe Treiberstufen 4 besitzen, die durch ein Steuersignal 5 angesteuert werden, welches die Weiterleitung des Ergebnisses veranlaßt, kann dieses Signal auch das Latch 6 transparent schalten, womit diese Einheit im Bedarfsfall volle Funktion zeigt. Ist das Latch 6 nicht aktiviert, so wird kein unnötiger Strom verbraucht. In Figur 1 ist beispielhaft für die unterste der Busleitungen 1 ein Transfergate 7 in der Zwischenspeichereinheit dargestellt. Dies stellt die einfachste Art der Abkopplung der Funktionseinheit vom Bus 1 dar.

Der zuvor genannte 16-Bit Mikrocontroller SAB80C166 weist im wesentlichen fünf Verarbeitungseinheiten auf. Wird eine erfindungsgemäße Stromsparschaltung angewendet, so kann in Summe die Stromaufnahme dieser Einheiten auf ca. 1/5tel gesenkt werden, wobei angenommen wird, daß alle Einheiten ungefähr gleich viel Strom aufnehmen.

Von besonderem Vorteil dieser erfindungsgemäßen Schaltung ist, daß der Anwender das Stromsparen nicht durch einen künstlichen Befehl starten oder beenden muß, sondern daß dies automatisch erfolgt. Dadurch wird Strom bei allen Funktionseinheiten gespart und nicht nur bei den Anwendungen, bei denen die Entwickler die Stromsparmodi aktivieren, d.h. Funktionseinheiten gezielt durch Software abzuschalten.

Ein weiterer Vorteil besteht darin, daß Mikrocontroller mit integriertem ROM oft als Mikrocontroller ohne ROM verkauft werden. Insbesondere geschieht dies, wenn aufgrund von Produktionsfehlern das ROM nicht verwendet werden kann. Dadurch ergibt sich ein unterschiedlicher Stromverbrauch bei Mikrocontrollern ohne ROM im Vergleich zu Mikrocontrollern mit defektem ROM. Wird ein derartiger Mikrocontroller mit einer erfindungsgemäßen Schaltungsanordnung versehen, so verbraucht jedoch das ROM aufgrund der obenbeschriebenen Maßnahmen keinen Strom mehr und es ist im Vergleich zum echten ROM-losen Mikrocontroller kein Unterschied im Stromverbrauch mehr vorhanden.

## Patentansprüche

1. Integrierte Schaltungsanordnung zur Reduzierung der Stromaufnahme mit einer Vielzahl von Funktionseinheiten, welche über Busleitungen miteinander verbunden sind, wobei über die Busleitungen Daten und/oder Adressen und Steuersignale übertragen werden,
**dadurch gekennzeichnet,** daß zur Reduzierung der Stromaufnahme wenigstens eine Zwischenspeichereinheit (6) vorgesehen ist, die zwischen die Busleitungen (1) und die jeweilige Funktionseinheit (2) geschaltet ist und daß diese Zwischenspeichereinheit (6) die jeweiligen Busleitungssignale (1) in Abhängigkeit von einem zugehörigen Steuersignal (5) steuert, wobei die Signale der Busleitungen (1) bei aktiviertem Steuersignal (5) an die Funktionseinheit (2) durchgeschaltet werden und bei nicht aktiviertem Steuersignal (5) keines der Busleitungssignale an die Funktionseinheit (2) übertragen wird, so daß die jeweiligen Eingänge der Funktionseinheit (2) nicht aktiviert werden.

2. Schaltungsanordnung nach Anspruch 1,
**dadurch gekennzeichnet,** daß das Steuersignal (5) aus einem jeweiligen Freigabesignal für die Ausgänge der jeweiligen Funktionseinheit (2) abgeleitet wird.

3. Schaltungsanordnung nach einem der vorhergehenden Ansprüche,
**dadurch gekennzeichnet,** daß die integrierte Schaltungsanordnung ein Mikroprozessor ist und eine der Funktionseinheiten ein ROM ist.

4. Schaltungsanordnung nach einem der vorhergehenden Ansprüche,
**dadurch gekennzeichnet,** daß als Zwischenspeichereinheit ein Latch (6) verwendet wird.

5. Schaltungsanordnung nach einem der Ansprüche 1 bis 3,
**dadurch gekennzeichnet,** daß als Zwischenspeichereinheit ein Transfergate (7) verwendet wird.
